# EUROPÄISCHE PATENTSCHRIFT

(11) **EP 0 686 328 B1**
(45) Veröffentlichungstag und Bekanntmachung des Hinweises auf die Patenterteilung: **17.02.1999**
(21) Anmeldenummer: 94904176.8
(22) Anmeldetag: 23.12.1993
(51) Int. Cl.: H04L 9/00, G11C 7/00

(54) **DIGITALES DIKTIERSYSTEM MIT SCHUTZVORRICHTUNG GEGEN UNBEFUGTES ABHÖREN**
DIGITAL DICTATION SYSTEM WITH PROTECTION AGAINST UNAUTHORISED LISTENING-IN
SYSTEME NUMERIQUE DE DICTEE AVEC UN DISPOSITIF DE PROTECTION CONTRE L'ECOUTE NON-AUTORISEE

(30) Priorität: 26.02.1993 DE 4305960
(43) Veröffentlichungstag der Anmeldung: 13.12.1995
(73) Patentinhaber: GRUNDIG Aktiengesellschaft, 90762 Fürth (DE)
(72) Erfinder: ZELL, Horst, D-90427 Nürnberg (DE)
(86) Internationale Anmeldenummer: EP9303663
(87) Internationale Veröffentlichungsnummer: WO9419886

(56) Entgegenhaltungen:
- DE-A- 3 811 378
- DE-A- 4 139 197
- DE-A- 4 228 692
- DE-U- 8 810 352

## Beschreibung

Die Erfindung betrifft ein digitales Diktiersystem mit Schutzvorrichtung gegen unbefugtes Abhören gemäß dem Oberbegriff des Patentanspruchs 1.

Aus der DE 42 28 692 A1 ist eine Chipkarte bekannt, die einen Halbleiterspeicher zur Speicherung digitaler Audio- oder Videosignale enthält. In einer Vorrichtung zur Anwendung dieser Chipkarte wird das von der Signalquelle kommende analoge Audio- oder Videosignal zunächst digitalisiert und dann einem Komprimierungsmodul zugeführt, um bei definierter Speicherkapazität eine möglichst lange Aufnahmedauer zu erzielen. Die Druckschrift verweist auch auf eine Sicherungslogik, die mit Hilfe eines auf der Chipkarte integrierten Prozessors realisiert ist. Sie gibt aber keinen Hinweis, in welcher Weise die auf der Chipkarte gespeicherten Informationen gesichert sind und durch welche Maßnahmen ein Zugriff auf den Speicherinhalt bei Austausch der Chipkarte zwischen verschiedenen Aufnahme- und Wiedergabegeräten verhindert oder ermöglicht wird.

Die DE 88 10 352 U1 offenbart ein stationäres und mobiles Diktiergerät mit statisch betriebenem Tonträger in Chipkartenausführung, wobei der digitale Tonträger zwischen einem stationär betriebenen Wiedergabegerät und einem mobil betriebenen Hand-Aufnahme/Wiedergabe-Gerät transferiert wird. Die Druckschrift vermittelt jedoch keine Anregung zum Schutz der gespeicherten Information gegen unbefugtes Abhören.

Die DE 41 39 197 A1 beschreibt eine Halbleiter-Speichereinheit zur Verwendung in Verbindung mit einer Datenverarbeitungseinrichtung, bei der der Zugriff auf abgespeicherte Daten erst freigegeben wird, wenn ein extern zugeführtes Adreßsignal mit einem innerhalb der Speichereinheit erzeugten Sicherheitscode übereinstimmt. Die Druckschrift gibt jedoch keinen hinweis auf eine Schutzvorrichtung gegen unbefugtes Abhören von Diktaten innerhalb eines digitalen Diktiersystems, bestehend aus mobilen und stationären Diktiergeräten. Darüberhinaus offenbart die genannte Druckschrift keine Möglichkeit, Halbleiter-Speichereinheiten individuell zu codieren, damit deren Zuordnung zu bestimmten Datenverarbeitungseinrichtungen oder Gerätebenutzergruppen beliebig geändert werden kann.

In der Zeitschrift "OEP" (Office Equipment & Products) vom Februar 1989 findet sich auf Seite 40 ein Hinweis auf ein digitales Handdiktiergerät der Firma Sanyo mit der Typenbezeichnung ICM-1. Als Speichermedium wird eine IC-Karte mit einem statischen RAM-Speicher verwendet. Uber einen Abhörschutz für das abgespeicherte Diktat findet sich aber auch in dieser Druckschrift kein Hinweis.

Die Verwendung einer IC-Karte als Speicherbaustein in einem Informationsaufzeichnungssystem ist auch aus der DE 38 11 378 A1 bekannt. Die IC-Karte beinhaltet einen Mikroprozessor, einen Halbleiterspeicher und einen magnetischen oder optischen Großspeicher. Der Zugriff auf den Großspeicher ist durch eine Adresseninformation gesichert, die im Halbleiterspeicher abgelegt ist und nur über den Mikroprozessor ausgelesen werden kann. Erst mit Hilfe dieser Adresseninformation können die an verschiedenen Speicherplätzen im Großspeicher abgelegten Daten in der richtigen Reihenfolge abgerufen werden. Um zusätzlich die gespeicherten Daten nur bestimmten Gerätebenutzern zugänglich zu machen oder nur mit ausgewählten Terminals auslesen zu können, enthält der Halbleiterspeicher außerdem entsprechende Kennungsinformationen, die beim Datenabruf zunächst mit jeweils einzugebenden Identifizierungscodes verglichen werden.

Abgesehen davon, daß zur eigentlichen Datenspeicherung ein magnetischer oder optischer Großspeicher benötigt wird, hat das beschriebene Informationsaufzeichnungssystem den Nachteil, vom Gerätebenutzer beim Einschreiben oder Auslesen von Daten besondere Sicherungsmaßnahmen zu verlangen, welche die Gerätebedienung erschweren. Außerdem kann, da der Großspeicher von der Außenseite der IC-Karte zugänglich ist, eine mit externen Mitteln betriebene Entschlüsselung der gespeicherten Daten nicht verhindert werden.

Der Gegenstand der vorliegenden Erfindung befaßt sich deshalb mit der Aufgabe, in einem digitalen Diktiersystem, bestehend aus mobilen und stationären Diktiergeräten, den Speicherinhalt der als Datenträger dienenden Chipkarten gegen unbefugtes Auslesen zu schützen und trotzdem das Abhören der gespeicherten Informationen auf den dafür bestimmten Wiedergabegeräten zu ermöglichen, ohne dabei vom Gerätebenutzer jeweils besondere Entschlüsselungsmaßnahmen zu verlangen. Ferner soll verhindert werden, daß durch nachträgliches Umcodieren der Chipkarten die im Datenspeicher durch den bisher vorhandenen Code gesicherten Informationen ausgelesen werden können. Ebenso muß das externe Abfragen eines Sicherungscodes aus dem Datenspeicher einer Chipkarte zum manipulierten Umcodieren eines Wiedergabegerätes unmöglich sein.

Diese Aufgabe wird durch ein digitales Diktiersystem mit den kennzeichnenden Merkmalen des Anspruchs 1 gelöst. Vorteilhafte Ausgestaltungen der Erfindung sind in den Unteransprüchen offenbart.

Das digitale Diktiersystem gemäß Anspruch 1 hat den Vorteil, daß die auf einer austauschbaren Chipkarte gespeicherten Informationen nur auf solchen Wiedergabegeräten abgehört werden können, die aufgrund eines frei wählbaren Codes vom Systembetreuer zuvor bestimmt wurden.

Anspruch 2 zeigt eine vorteilhafte Gerätekonfiguration auf, mit der die individuelle Codierung der innerhalb eines Diktiersystems zusammenwirkenden Diktiergeräte erfolgen kann, ohne einem Außenstehenden den gewählten Sicherungscode zugänglich zu machen.

Der Vorteil des Diktiersystems gemäß Anspruch 3 liegt darin, daß unterschiedlich codierte Chipkarten bei Diktat-Neuaufnahmen auf beliebigen Aufnahmegeräten verwendet werden können, ohne dadurch den bisherigen Speicherinhalt des Datenspeichers preiszugeben.

Mit dem Merkmal des Anspruchs 4 kann in vorteilhafter Weise der Speicherinhalt der Chipkarten auf beliebigen Wiedergabegeräten ausgelesen werden, sofern kein Wert auf Vertraulichkeit gelegt wird.

Anspruch 5 offenbart als Vorteil des beschriebenen digitalen Diktiersystems, daß die als Datenträger fungierenden Chipkarten zur Datensicherung keine karteneigene Spannungsversorgung benötigen.

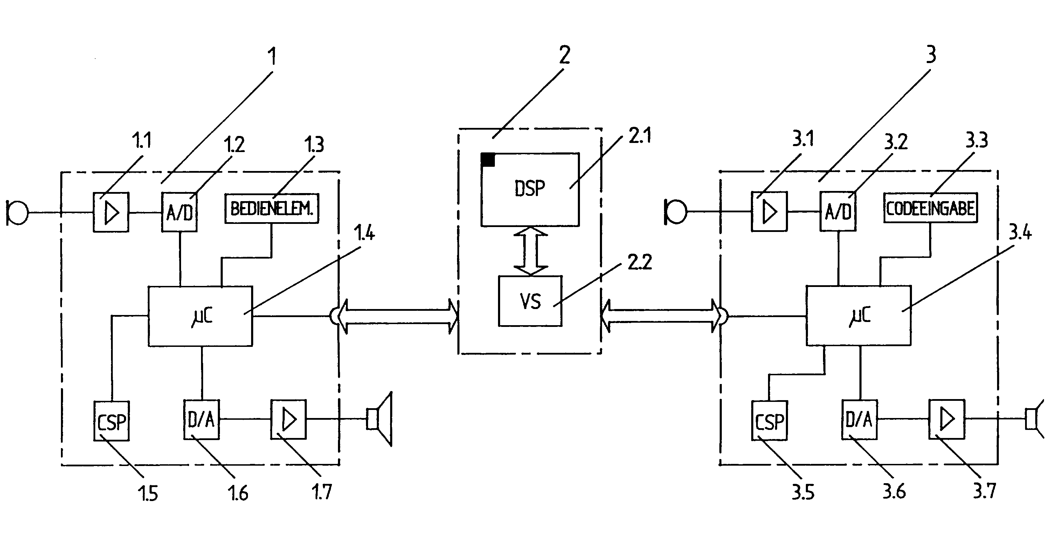

Die Erfindung wird nachstehend anhand der Zeichnung erlautert.

Die einzige Figur zeigt als Blockschaltbild die prinzipielle Gerätekonfiguration des erfindungsgemäßen Diktiersystems.

Das in der Zeichnung dargestellte digitale Diktiersystem besteht aus einem oder mehreren mobilen Hand-Diktiergeräten 1, einer damit kontaktierbaren, in Form einer Chipkarte ausgeführten Speicherkarte 2 und aus einem oder mehreren stationären Büro-Diktiergeräten 3, die zur Kontaktierung der vorerwähnten Chipkarte eingerichtet sind.

Die mobilen und stationären Diktiergeräte unterscheiden sich zunächst nur durch ihren konstruktiven Aufbau, durch die Art der Stromversorgung und durch die auf die Anwendung zugeschnittenen Bedienfunktionen. Beide Geräteausführungen beinhalten einen analogen Signalverstärker 1.1 bzw. 3.1 zur Verstärkung der von einem Mikrofon kommenden Sprachsignale, einen Analog/Digitalwandler 1.2 bzw. 3.2 zum Umsetzen der Sprachsignale in digitale Daten und einen Mikrocomputer 1.4 bzw. 3.4 zur Komprimierung und Adressierung der digitalen Sprachdaten sowie zur Steuerung diverser Gerätefunktionen. Diese Funktionen können auch durch einen separaten digitalen Signalprozessor und eine zusätzliche Steuerschaltung ausgeführt werden.

Die von dem jeweils zur Aufnahme verwendeten Diktiergerät generierten digitalen Sprachdaten werden über eine Vergleichsschaltung 2.2 auf der Speicherkarte 2 in den zugehörigen Datenspeicher 2.1 eingeschrieben. Dieser Speicher kann beispielsweise aus einem nichtflüchtigen Flash-EEPROM-Speicher bestehen, wobei dieser Speichertyp der nachstehend erläuterten Code-Sicherung entgegenkommt, da ein einfaches Uberschreiben des Speichers ohne vorherige Löschung des Speichers bzw. Speicherbereiches nicht möglich ist. Es können aber auch alle anderen Arten von nichtflüchtigen Speichern eingesetzt werden. Wichtig ist, daß die Dateneingabe und der spätere Zugriff auf diese Daten zur Wiedergabe nur über die Vergleichsschaltung 2.2 erfolgt, wobei sowohl die Dateneingabe als auch die Datenabfrage durch die Vergleichsschaltung 2.2 blockiert wird, wenn, wie später beschrieben, der in einem Speicherbereich des Datenspeichers 2.1 abgelegte Sicherungscode nicht mit einem vom jeweils kontaktierten Diktiergerät gelieferten Code übereinstimmt.

Für die Wiedergabe der auf der Speicherkarte 2 gespeicherten Informationen, die sowohl über ein mobiles Hand-Diktiergerät 1 als auch über ein stationäres Bürodiktiergerät 3 erfolgen kann, werden die Sprachdaten im Mikrocomputer 1.4 bzw. 3.4 dekomprimiert, im Digital/Analog-Wandler 1.6 bzw. 3.6 in ein analoges Sprachsignal umgesetzt und über den analogen Endverstärker 1.7 bzw. 3.7 einem Lautsprecher zugeführt.

Soweit es also die Signalverarbeitung für Aufnahme und Wiedergabe von Informationen betrifft, bestehen keine prinzipiellen Unterschiede zwischen den mobilen und stationären Diktiergeräten.

Gemäß der Erfindung sind aber die mobilen und stationären Diktiergeräte derart eingerichtet, daß sie in Verbindung mit der als Datenträger dienenden Chipkarte über einen individuell wählbaren Code ein unbefugtes Abhören der auf der Chipkarte gespeicherten Informationen verhindern.

Dieser Code wird zunächst dem im Diktiersystem verwendeten stationären Bürogerät 3 über einen versteckt angeordneten Code-Wahlschalter eingegeben und mechanisch fixiert, oder er wird über eine Code-Eingabetastatur 3.3, die auch in Doppelfunktion Teil einer allgemeinen Bedienungstastatur sein kann, in den Code-Speicher 3.5 eingeschrieben. Ist eine Speicherkarte 2 im stationären Gerät 3 eingelegt, so wird zunächst der Datenspeicher 2.1 vollständig gelöscht und der Code aus dem Code-Speicher 3.5 automatisch in einen Speicherbereich des Datenspeichers 2.1 kopiert. Es ist aber auch möglich, durch Auslösen der Aufnahmefunktion ein Kopieren des Codes einzuleiten. In diesem Fall sendet das stationäre Diktiergerät 3 den in seinem Code-Speicher 3.5 enthaltenen Code an die Vergleichsschaltung 2.2, welche die Ubereinstimmung mit einem evtl. auf der Speicherkarte 2 bereits abgelegten Code überprüft. Kann keine Ubereinstimmung festgestellt weden, so fordert das stationäre Diktiergerät den Benutzer durch ein optisches oder akustisches Signal auf, den Datenspeicher 2.1 über entsprechende Befehlseingabe in das Diktiergerät 3 zu löschen. Wird anschließend wieder das Diktiergerät 3 in Aufnahmebereitschaft versetzt, so wird automatisch der Code aus dem Code-Speicher 3.5 in einen Teilbereich des Datenspeichers 2.1 kopiert.

Die auf diese Weise codierte Speicherkarte 2 kann nun dazu verwendet werden, beliebig viele mobile Hand-Diktiergeräte mit demselben Code zu versehen. Zu diesem Zweck wird die Speicherkarte in das entsprechende Hand-Diktiergerät eingeschoben und zwei oder mehrere Tasten der vorhandenen Bedientastatur gleichzeitig oder in bestimmter zeitlicher Folge betätigt. Das mobile Gerät 1 prüft zunächst über die Vergleichsschaltung 2.2, ob ein evtl. bereits vorhandener Code im Code-Speicher 1.5 des Handgerätes mit dem im Datenspeicher 2.1 der Speicherkarte 2 fixierten Code übereinstimmt. Wird eine Ubereinstimmung verneint und erkennt die Vergleichsschaltung 2.2, daß der zur Signalspeicherung vorgesehene Teil des Datenspeichers 2.1 zumindest teilweise belegt ist, so fordert das mobile Diktiergerät 1 den Benutzer durch ein optisches oder akustisches Signal auf, den Datenspeicher 2.1 der Speicherkarte 2 durch entsprechende Befehlseingabe zu löschen. Dabei wird jedoch nicht der Speicherbereich des Datenspeichers 2.1 gelöscht, in dem der Sicherungscode abgelegt ist. Anschließend wird automatisch der im Datenspeicher 2.1 enthaltene Code in den Code-Speicher 1.5 des mobilen Diktiergerätes 1 übertragen und die durch die anfängliche kombinierte Tastenbetätigung eingeleitete Programmierungsroutine durch ein akustisches Signal zur Bestätigung der erfolgreichen Codierung des mobilen Hand-Diktiergerätes 1 abgeschlossen. Eine alphanumerische Anzeige der eingegebenen Code-Zahl erfolgt nicht, um Manipulationsversuche mit anderen Geräten zu verhindern.

Die Aufforderung zum Löschen des Signal-Speicherbereiches des Datenspeichers 2.1 entfällt, wenn bei der Programmierungsroutine die Vergleichsschaltung 2.2 feststellt, daß entweder der Signal-Speicherbereich des Datenspeichers 2.1 nicht belegt ist oder im Code-Speicher 1.5 des mobilen Hand-Diktiergerätes 1 bereits der aus dem Datenspeicher 2.1 zu übertragende Code vorliegt.

Sind die mobilen und stationären Geräte einer bestimmten Diktiergeräteformation mit demselben Code programmiert, so können für die Aufnahme von Diktaten beliebige Speicherkarten verwendet werden. Sobald das jeweilige Aufnahmegerät in Aufnahmebereitschaft versetzt wird, prüft die Vergleichsschaltung 2.2, ob der Code der Speicherkarte 2 mit dem Code des Aufnahmegerätes übereinstimmt und fordert bei Nichtübereinstimmung zunächst den Gerätebenutzer durch ein optisches oder akustisches Signal auf, den gesamten Speicherinhalt des Datenspeichers 2.1 zu löschen. Beim anschließenden Aufnahmevorgang wird der im Codespeicher 1.5 oder 3.5 vorhandene Code automatisch in den Datenspeicher 2.1 der Speicherkarte 2 kopiert.

Soll innerhalb einer bestimmten Diktiergeräteformation sichergestellt werden, daß die auf der Speicherkarte gespeicherten Informationen auch auf beliebig codierten fremden Wiedergabegeräten auslesbar sind, so können die Geräte der zur Diktataufnahme verwendeten Formation mit einem Universalcode programmiert werden, der die Code-Sicherung praktisch außer Betrieb setzt. In diesem Zustand werden beispielsweise die einzelnen Diktiergeräte von der Fabrik an den Kunden ausgeliefert, so daß Diktate, die auf Neugeräten aufgenommen wurden, auch ohne vorherige individuelle Codierung dieser Geräte auf kundenseits bereits vorhandenen und beliebig codierten Wiedergabegeräten abgehört werden können.

Die auf der Speicherkarte 2 vorhandene Vergleichsschaltung 2.2, die beispielsweise aus einem Mikroprozessor bestehen kann, dient sowohl dem Code-Vergleich als auch dem Datentransfer zwischen Diktiergerät 1 bzw. 3 und Speicherkarte 2. Sie verhindert vor allem den direkten Zugriff auf den im Datenspeicher 2.1 abgelegten Code und die dort gespeicherten Informationsdaten. Da sie jedoch erst zum Datenaustausch aktiviert werden muß, erfolgt ihre Spannungsversorgung erst bei Kontaktierung mit dem jeweils verwendeten Aufnahme- oder Wiedergabegerät. Da als Datenspeicher 2.1 ein nichtflüchtiger Speicher verwendet wird, benötigt die Speicherkarte 2 in vorteilhafter Weise keine Stützbatterie, so daß ihre Funktionsfähigkeit ohne zeitliche Begrenzung gewährleistet ist.

## Patentansprüche

1. Digitales Diktiersystem mit Schutzvorrichtung gegen unbefugtes Abhören, bestehend aus mobilen und/oder stationären Diktiergeräten als Aufnahme- und/oder Wiedergabegeräte mit Einrichtungen zum Wandeln der analogen Sprachsignale in digitale Daten und umgekehrt, und mit Datenträgern in Form von austauschbaren Speicherkarten mit digitalem Halbleiterspeicher,
**dadurch gekennzeichnet,** daß jede einzelne Speicherkarte (2) so ausgebildet ist, daß
a) der Speicherinhalt des Datenspeichers (2.1) auf der Speicherkarte (2) durch einen frei wählbaren, in einen Teilbereich des Datenspeichers (2.1) einzuschreibenden Code gegen unbefugtes Auslesen geschützt ist,
b) über eine Vergleichsschaltung (2.2) auf der Speicherkarte (2) eine Sperre zum Auslesen des im Datenspeicher (2.1) abgelegten Diktates erst dann aufgehoben wird, wenn der vom Wiedergabegerät an die Speicherkarte (2) übermittelte Code mit dem auf der Speicherkarte abgelegten Code übereinstimmt,
c) der auf der Speicherkarte abgelegte Code nur von der Vergleichsschaltung (2.2) abfragbar ist, jedoch ein externes Auslesen des Codes über die Kontaktierung der Speicherkarte unmöglich ist und
d) der auf der Speicherkarte abgelegte Sicherungscode nur dann durch einen neuen Code ersetzt werden kann, wenn zuvor der gesamte Speicherinhalt des Datenspeichers (2.1) gelöscht wurde.

2. Digitales Diktiersystem mit Schutzvorrichtung gegen unbefugtes Abhören nach Anspruch 1,
**dadurch gekennzeichnet,** daß das digitale Diktiersystem so ausgebildet ist, daß die Code-Zahl in einem stationären Diktiergerät (3) über verborgen angeordnete Code-Schalter oder über eine Eingabetastatur (3.3) generiert und auf eine Speicherkarte (2) übertragen wird, wobei der gesamte Inhalt des Datenspeichers (2.1) zuvor gelöscht wird, und daß mit Hilfe dieser so codierten Speicherkarte mobile Diktiergeräte (1) durch gleichzeitiges Betätigen zweier oder mehrerer vorhandener Tasten Code-programmiert werden können, wobei die Codeübernahme akustisch oder optisch bestätigt, die Code-Zahl aber nicht angezeigt wird.

3. Digitales Diktiersystem mit Schutzvorrichtung gegen unbefugtes Abhören nach Anspruch 1 oder 2,
**dadurch gekennzeichnet,** daß das digitale Diktiersystem so ausgebildet ist, daß bei jeder Aufnahme auf einem mobilen oder stationären Diktiergerät (1, 3) der geräteintern gespeicherte Code mit dem auf der Speicherkarte (2) eventuell vorhandenen Code verglichen wird und daß bei fehlender Übereinstimmung der beiden Codes eine Aufnahme nur möglich ist, wenn zuvor der gesamte Speicherinhalt des Datenspeichers (2.1) gelöscht wurde, wobei dann bei der Aufnahme der geräteintern gespeicherte Code automatisch auf die Speicherkarte übertragen wird.

4. Digitales Diktiersystem mit Schutzvorrichtung gegen unbefugtes Abhören nach einem der vorstehenden Ansprüche,
**dadurch gekennzeichnet,** daß das digitale Diktiersystem so ausgebildet ist, daß für das unbeschränkte Auslesen gespeicherter Diktate auf beliebigen Wiedergabegeräten die Code-Sicherung durch Eingabe eines Universal-Codes in das zur Code-Programmierung der mobilen Diktiergeräte (1) vorgesehene stationäre Diktiergerät (3) außer Betrieb gesetzt werden kann.

5. Digitales Diktiersystem mit Schutzvorrichtung gegen unbefugtes Abhören nach einem der vorstehenden Ansprüche,
**dadurch gekennzeichnet,** daß das digitale Diktiersystem so ausgebildet ist, daß erst beim Einstecken einer Speicherkarte (2) in ein mobiles oder statonäres Diktiergerät (1, 3) die auf der Speicherkarte integrierte Vergleichsschaltung (2.2) mit Strom versorgt wird.

## Claims

1. Digital dictation system having a protection device against unauthorized listening-in, comprising mobile and/or stationary dictation machines as recording and/or playback machines having facilities for converting the analog speech signals into digital data and vice versa, and having data media in the form of interchangeable memory cards comprising digital semiconductors, characterized in that each individual memory card (2) is designed so that
a) the memory contents of the data memory (2.1) on the memory card (2) are protected against unauthorized reading-out by a freely selectable code to be written into a subregion of the data memory (2.1),
b) a barrier to reading-out the dictation stored in the data memory (2.1) is cancelled via a comparison circuit (2.2) on the memory card (2) only if the code transmitted by the playback machine to the memory card (2) coincides with the code stored on the memory card,
c) the code stored on the memory card can be scanned only by the comparison circuit (2.2), but an external reading-out of the code by means of contacting the memory card is impossible, and
d) the security code stored on the memory card can be replaced by a new code only if the entire memory contents of the data memory (2.1) have been erased beforehand.

2. Digital dictation system having a protection device against unauthorized listening-in according to Claim 1, characterized in that the digital dictation system is designed so that the code number is generated in a stationary dictation machine (3) by means of code switches disposed in a concealed manner or by means of an input keyboard (3.3) and is transferred to a memory card (2), the entire contents of the data memory (2.1) being erased beforehand, and in that mobile dictation machines (1) can be code-programmed with the aid of said memory cards coded in this way by simultaneous operation of two or more available keys, the code acceptance being confirmed audibly or visually, but the code number not being indicated.

3. Digital dictation system having a protection device against unauthorized listening-in according to Claim 1 or 2, characterized in that the dictation system is designed so that, for every recording on a mobile or stationary dictation machine (1, 3), the code stored internally in the machine is compared with the code possibly present on the memory card (2) and in that, if coincidence of the two codes is absent, a recording is possible only if the entire memory contents of the data memory (2.1) have been erased beforehand, the code stored internally in the machine then being automatically transferred to the memory card during the recording.

4. Digital dictation machine having a protection device against unauthorized listening-in according to one of the preceding claims, characterized in that the digital dictation system is designed so that, for the unlimited reading-out of stored dictations on any playback machine, the code security can be put out of operation by entering a universal code in the stationary dictation machine (3) provided for the code programming of mobile dictation machines (1).

5. Digital dictation machine having a protection device against unauthorized listening-in according to one of the preceding claims, characterized in that the digital dictation system is designed so that the comparison circuit (2.2) integrated on the memory card is supplied with current only when a memory card (2) is plugged into a mobile or stationary dictation machine (1, 3).

## Revendications

1. Système numérique de dictée comportant un dispositif de protection contre une écoute non autorisée, constitué par des appareils mobiles et/ou fixes de dictée en tant qu'appareils d'enregistrement et/ou de reproduction comportant des dispositifs pour convertir des signaux vocaux analogiques en des données numériques et inversement, et comportant des supports de données sous la forme de cartes de mémoire remplaçables comportant des mémoires numériques à semiconducteurs,
caractérisé en ce que chaque carte individuelle de mémoire (2) est agencée de telle sorte que
a) le contenu de la mémoire de données (2.1) sur la carte de mémoire (2) est protégé, vis-à-vis d'une lecture non autorisée, par un code pouvant être choisi librement et devant être écrit dans une zone partielle de la mémoire de données (2.1),
b) un blocage pour la lecture de la dictée mémorisée dans la mémoire de données (2.1) est supprimé par l'intermédiaire d'un circuit comparateur (2.2) situé sur la carte de mémoire (2), uniquement lorsque le code transmis par l'appareil de reproduction à la carte de mémoire (2) coïncide avec le code mémorisé dans la carte de mémoire,
c) le code mémorisé dans la carte de mémoire peut être interrogé uniquement par le circuit comparateur (2.2), mais une lecture externe du code au moyen de l'établissement d'un contact avec la carte de mémoire est impossible, et
d) le code de sécurité mémorisé dans la carte de mémoire peut être remplacé par un nouveau code uniquement lorsqu'au préalable l'ensemble du contenu de la mémoire de données (2.1) a été effacé.

2. Système numérique de dictée comportant un dispositif de protection contre une écoute non autorisée selon la revendication 1,
caractérisé en ce que le système numérique de dictée est agencé de telle sorte que le nombre de code contenu dans un appareil de dictée fixe (3) est produit par l'intermédiaire d'un commutateur de code disposé d'une manière masquée, ou par l'intermédiaire d'un clavier d'entrée (3.3) et est transmis à une carte de mémoire (2), l'ensemble du contenu de la mémoire de données (2.1) étant préalablement effacé, et qu'à l'aide de cette carte de mémoire ainsi codée, des appareils mobiles de dictée (1) peuvent être ainsi programmés au moyen d'un code au moyen de l'actionnement simultané de deux ou de plusieurs touches présentes, le transfert du code étant confirmé acoustiquement ou optiquement, mais le numéro de code n'étant pas affiché.

3. Système numérique de dictée comportant un dispositif de protection contre une écoute non autorisée selon la revendication 1 ou 2, caractérisé en ce que le système numérique de dictée est agencé de telle sorte que lors de chaque enregistrement dans un appareil de dictée mobile ou fixe (1,3), le code mémorisé à l'intérieur de l'appareil est comparé au code éventuellement présent dans la carte de mémoire (2) et qu'en cas d'absence de coïncidence entre les deux codes, un enregistrement est possible uniquement lorsqu'au préalable l'ensemble du contenu de la mémoire de données (2.1) a été effacé, auquel cas ensuite lors de l'enregistrement du code mémorisé à l'intérieur de l'appareil, une transmission d'une carte de mémoire est exécutée automatiquement.

4. Système numérique de dictée comportant un dispositif de protection contre une écoute non autorisée selon l'une des revendications précédentes,
caractérisé en ce que le système numérique de dictée est agencé de telle sorte que pour la lecture non autorisée de dictées mémorisées dans n'importe quel appareil de reproduction, la sécurité du code peut être supprimée par introduction d'un code universel dans l'appareil fixe de dictée (3), qui est prévu pour la programmation du code des appareils mobiles de dictée (1).

5. Système numérique de dictée comportant un dispositif de protection contre une écoute non autorisée selcn l'une des revendications précédentes, caractérisé en ce que le système numérique de dictée est agencé de telle sorte que c'est seulement lors de l'enfichage d'une carte de mémoire (2) dans un appareil mobile ou fixe de dictée (1.3), que le circuit comparateur (2.2), qui est intégré dans la carte de mémoire, est alimenté en courant.
